# EUROPÄISCHE PATENTANMELDUNG

(11) **EP 0 985 907 A2**
(43) Veröffentlichungstag der Anmeldung: **15.03.2000**
(21) Anmeldenummer: 99117005.1
(22) Anmeldetag: 28.08.1999
(51) Int. Cl.: G01D 1/00

(54) **Sicherheitsrelevantes System, insbesondere elektromechanisches Bremssystem**

(30) Priorität: 08.09.1998 DE 19840944
(71) Anmelder: Continental Aktiengesellschaft, 30165 Hannover (DE)
(72) Erfinder: Behrends, Holger, 30559 Hannover (DE); Maron, Christof, Dr., 93128 Regenstauf (DE); Dieckmann, Thomas, Dr., 30982 Pattensen (DE)

(57) **Zusammenfassung**

Die Erfindung betrifft ein sicherheitsrelevantes Systems 2, in dem die Position einer Betätigungsvorrichtung 4 von drei unabhängig voneinander arbeitenden Sensoren 8, 10 und 12 aufgenommen wird. Der Sensor 8 wird von der ersten Energiequelle 20 und der Sensor 12 wird von der zweiten Energiequelle 22 des Systems 2 direkt mit Energie versorgt. Der Sensor 10 wird über eine Diodenschaltung 14, 16 entweder von der ersten Energiequelle 20 oder von der zweiten Energiequelle 22 mit Energie versorgt, so daß bei einem Ausfall der Energiequelle 20 bzw. 22 immer zwei Sensoren der drei Sensoren 8, 10 und 12 mit Energie versorgt werden. In den Mikroprozessoren 32 und 34 kann bei Ausfall des Meßsignals eines der Sensoren eine Mehrheitsentscheidung durchgeführt werden und darüber hinaus festgestellt werden, welche der Energiequellen 20 bzw. 22 ausgefallen ist.

## Beschreibung

Die Erfindung betrifft ein sicherheitsrelevantes System, insbesondere ein elektromechanisches Bremssystem, das folgende Bestandteile enthält:
- eine Betätigungsvorrichtung, die von einer Ausgangsposition in unterschiedliche Positionen überführbar ist,
- drei Sensoren, mit denen unabhängig voneinander ein der Position der Betätigungsvorrichtung entsprechendes Meßsignal erzeugbar ist, wobei der erste der drei Sensoren über einen ersten Versorgungspfad von einer ersten unabhängigen Energiequelle und der zweite der drei Sensoren über einen zweiten Versorgungspfad von einer zweiten unabhängigen Energiequelle mit Energie versorgt wird.

Bei einem Sensor, der ein der Position der Betätigungsvorrichtung entsprechendes Meßsignal erzeugt, kann es sich z. B. um einen Wegsensor handeln, der den Weg von der Ausgangsposition der Betätigungsvorrichtung in eine Betätigungsposition mißt. Es kann sich ebenfalls um einen Kraftsensor handeln, der die Kraft mißt, die notwendig ist, um die Betätigungsvorrichtung von der Ausgangsposition in eine Betätigungsposition zu überführen. Andere Ausgestaltungen des Sensors sind denkbar.

Die Erfindung wird im folgenden im Zusammenhang mit einem elektromechanischen Bremssystem erläutert. Sie kann jedoch auch in anderen sicherheitsrelevanten Systemen, beispielsweise in einem elektromechanischen Lenksystem, verwendet werden. In einem elektromechanischen Bremssystem entspricht die eingangs genannte Betätigungsvorrichtung dem Bremspedal. Der Bremswunsch des Fahrers eines Kraftfahrzeuges wird durch Ausüben einer Fußkraft auf das Bremspedal kundgetan und die Einwirkung der Fußkraft auf das Pedal wird von Sensoren erfaßt und in ein elektrisches Signal umgewandelt. Das Signal wird an Bremsaktuatoren weitergeleitet, von denen jeweils einer einem Rad des Kraftfahrzeuges zugeordnet ist und jeder Bremsaktuator übt unter zur Hilfenahme eines Elektromotors eine von dem Bremswunsch des Fahrers abhängige Bremskraft auf das Rad des Kraftfahrzeuges aus.

Aus der DE 195 10 525 A1 ist ein Verfahren zur Steuerung bzw. Regelung einer elektromechanischen Bremsanlage eines Kraftfahrzeugs bekannt. Die elektromechanische Bremsanlage weist ein Bremspedal auf, dessen Betätigung durch drei unabhängig voneinander arbeitende Sensoren erfaßt wird. Die von den Sensoren erzeugten Meßsignale werden an Mikroprozessoren eines Rechnersystems weitergeleitet. In den Mikroprozessoren findet u. a. eine Fehlerbetrachtung der Meßsignale statt. Darüber hinaus wird in den Mikroprozessoren aus den Meßsignalen der Sollwert für die von dem Fahrer gewünschte Bremskraft bestimmt. Dieser Sollwert wird nach Abschluß der Berechnungen von den Mikroprozessoren in dem elektomechanischen Bremssystem eingesteuert bzw. eingeregelt.

Die drei Sensoren des aus der DE 195 10 525 A1 bekannten Bremssystems verfügen jeweils über eine eigene Energieversorgung. Wird also infolge des Ausfalls einer Energiequelle einer der Sensoren nicht mehr mit Energie versorgt, so hat das für die Energieversorgung der übrigen Sensoren keine Folgen und es werden also weiterhin zwei von drei Meßsignalen erzeugt. In den Mikroprozessoren des Rechnersystems kann also auch in diesem Fall bei einem Bremsvorgang anhand einer Mehrheitsentscheidung festgestellt werden, welcher der drei Sensoren ausgefallen ist, und das Bremssystem kann weiterhin betrieben werden. Das aus der DE 195 10 525 A1 bekannte elektromechanische Bremssystem ist also auch dann noch als sicher zu bezeichnen, wenn eine der Energiequellen, die einen Sensor versorgt, ausfällt. Es ist jedoch festzustellen, daß das elektromechanische Bremssystem durch das Vorhandensein von drei Sensoren, die jeweils von einer unabhängigen Energiequelle versorgt werden, einen aufwendigen Aufbau aufweist.

Der Erfindung liegt die Aufgabe zugrunde, ein sicherheitsrelevantes System zu schaffen, das einen einfachen Aufbau und dennoch einen hohen Sicherheitsstandard aufweist.

Gemäß den kennzeichnenden Merkmalen den Anspruchs 1 wird die Aufgabe dadurch gelöst, daß
- der erste und der zweite Versorgungspfad über eine Verbindungsleitung miteinander verbunden sind, die zwei Dioden bzw. zwei Elemente, die jeweils die Funktion einer Diode haben, enthält und
- daß zwischen der ersten und der zweiten Diode ein dritter Versorgungspfad von der Verbindungsleitung abzweigt, der zu dem dritten Sensor führt, und
- daß die Dioden derartig in der Verbindungleitung orientiert sind, daß die Durchflußrichtung der ersten Diode von der ersten Versorgungsleitung zur dritten Versorgungsleitung und die Druchflußrichtung der zweiten Diode von der zweiten Versorgungsleitung zur dritten Versorgungsleitung weist.

Die mit der Erfindung erzielten Vorteile sind insbesondere darin zu sehen, daß das sicherheitsrelevante System nur zwei Energiequellen, also mindestens eine Energiequelle weniger als das aus der DE 195 10 525 A1 bekannte sicherheitsrelevante System, aufweist. Durch den Verzicht auf mindestens eine Energiequelle läßt sich der Aufbau des sicherheitsrelevanten Systems erheblich vereinfachen. Darüber hinaus sinken die Kosten für das sicherheitsrelevante System, da nur noch zwei Energiequellen benötigt werden und nur noch der Ladungszustand von zwei Energiequellen mit entsprechenden Bauteilen überwacht zu werden braucht.

Trotz dieser Vorteile weist das erfindungsgemäße sicherheitsrelevante System den gleichen Sicherheitsstandard auf wie das aus der DE 195 10 525 A1 bekannte sicherheitsrelevante System. So ist festzustellen, daß bei dem Ausfall einer der beiden Energiequellen weiterhin zwei von drei Sensoren wie folgt mit elektrischer Energie versorgt werden: Einer der drei Sensoren wird 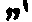 direkt" von der nicht ausgefallenen Energiequelle mit Energie versorgt; der dritte Sensor wird über den Versorgungspfad, der von der nicht ausgefallenen Energiequelle über die Diode, deren Durchflußrichtung von der nicht ausgefallenen Energiequelle zu dem dritten Versorgungspfad weist, führt, mit Energie versorgt. Da bei dem Ausfall einer der beiden Energiequellen noch zwei von drei Sensoren mit Energie versorgt werden, ist es weiterhin möglich, in einem Mikroprozessor des sicherheitsrelevanten Systems einen Mehrheitsentscheid darüber durchzuführen, welcher der drei Sensoren ausgefallen ist und dann darauf rückzuschließen, welche der Energiequellen ausgefallen ist.

Ein weiterer Vorteil der Erfindung ist darin zu sehen, daß der dritte Sensor des Systems unabhängig davon, welche der Energiequellen ausfällt, immer mit Energie versorgt wird (der dritte Sensor wird nur dann nicht mit Energie versorgt, wenn beide Energiequellen gleichzeitig ausfallen, was jedoch einem Totalausfall des Systems entspricht und sehr unwahrscheinlich ist). Aufgrund dessen kann man dem dritten Sensor eine besondere Wichtigkeit, z. B. in Form einer besonders hohen Meßgenauigkeit, verleihen.

Gemäß einer Weiterbildung der Erfindung nach Anspruch 2 verfügt das sicherheitsrelevante System über mindestens zwei funktional voneinander unabhängige Kreise, wobei der erste Kreis von der ersten Energiequelle und der zweite Kreis von der zweiten Energiequelle mit Energie versorgt wird und jedem Kreis die Meßsignale aller drei Sensoren zugeführt werden. Der Vorteil dieser Weiterbildung ist darin zu sehen, daß bei dem Ausfall einer der beiden Kreise (beispielsweise durch Ausfall einer Energiequelle) weiterhin der andere Kreis des sicherheitsrelevanten Systems funktioniert. Ein weiterer Vorteil der Weiterbildung ist darin zu sehen, daß die Meßsignale aller drei Sensoren in jedem Kreis des sicherheitsrelevanten Systems vorliegen, so daß die Meßsignale der Sensoren unabhängig voneinander in jedem sicherheitsrelevanten Kreis verarbeitet werden können.

Gemäß einer Weiterbildung der Erfindung nach Anspruch 3 werden die Meßsignale aller drei Sensoren in jedem Kreis einer intelligenten Einheit zugeführt, wobei in der intelligenten Einheit (beispielsweise einem Mikroprozessor) eine Mehrheitsentscheidung und ggf. eine Plausibilitätsbetrachtung durchgeführt wird. Der Vorteil dieser Weiterbildung ist darin zu sehen, daß die Überprüfung der Meßsignale der drei Sensoren in intelligenten Einheiten durchgeführt wird, die in dem sicherheitsrelevanten System ohnehin vorhanden sind. So verfügt beispielsweise jeder Bremsaktuator eines elektromechanischen Bremssystems über einen Mikroprozessor, mit dessen Hilfe an dem Bremsaktuator der Sollwert für die Bremskraft eingesteuert bzw. eingeregelt wird. Durch das Zurückgreifen auf ohnehin vorhandene intelligente Einheiten in dem sicherheitsrelevanten System kann auf zusätzliche Mikroprozessoren, die ausschließlich für die zentrale Überprüfung der Meßsignale zuständig wären und das Ergebnis dann in dem System verteilen würden, verzichtet werden. Hierdurch ergibt sich eine wesentliche Einsparung, da man aus Sicherheitsgründen mindestens drei weitere Mikroprozessoren zur Verfügung stellen müßte, um die Meßsignale zu überprüfen. Würde nämlich einer der Mikroprozessoren, die die Meßsignale überprüfen, ausfallen, so müßte dieses wiederum mit Hilfe einer Mehrheitsentscheidung durch die anderen beiden Mikroprozessoren festgestellt werden. Wertet man die Meßsignale hingegen beispielsweise in dem Mikroprozessor eines Bremsaktuators aus, so führt ein Ausfall dieses Mikroprozessors lediglich dazu, daß dieser eine Bremsaktuator nicht mehr gesteuert bzw. geregelt werden kann, wohingegen die anderen Bremsaktuatoren voll funktionstüchtig bleiben.

Gemäß einer Weiterbildung der Erfindung nach Anspruch 4 enthält jede Signalleitung, die von einem der Sensoren zu einem der Kreise des Systems führt, eine Signalkreisschutzschaltung, über die eine elektrische Entkopplung zwischen dem Sensor und dem jeweiligen Kreis des Systems vorgenommen wird, wenn in dem jeweiligen Kreis ein elektrischer Fehler auftritt. Der Vorteil dieser Weiterbildung ist darin zu sehen, daß die Sensoren auch dann weiterhin arbeiten, wenn in einem der Kreise des sicherheitsrelevanten Systems ein elektrischer Fehler auftritt, so daß die Meßsignale aller Sensoren weiterhin für den anderen Kreis des sicherheitsrelevanten Systems zur Verfügung stehen. Im einfachsten Fall kann die Signalkreisschutzschaltung als Sicherung ausgebildet sein, weitere mögliche Aufbauten der Signalkreisschutzschaltung sind dem Fachmann bekannt.

Gemäß einer Weiterbildung der Erfindung nach Anspruch 5 befinden sich zwischen dem jeweiligen Sensor und der Signalkreisschutzschaltung keine elektrischen Bestandteile des jeweiligen Kreises. Der Vorteil dieser Weiterbildung ist darin zu sehen, daß die Signalkreisschutzschaltung den jeweiligen Sensor bei dem Ausfall eines jeden elektrischen Bestandteil des jeweiligen Kreises von diesem Kreis entkoppelt.

Gemäß einer Weiterbildung der Erfindung nach Anspruch 6 ist für jeden Kreis des sicherheitsrelevanten Systems ein separater Stecker vorhanden, über den die Signale aller drei Sensoren dem jeweiligen Kreis zugeführt werden. Die Stecker, über die die Kreise des sicherheitsrelevanten Systems mit den Sensoren verbunden sind, sind insofern als sicherheitsrelevante Bestandteile des Systems zu betrachten, als daß sie z. B. 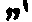 abfallen" können. Durch die redundante Ausbildung der Stecker wird also die Sicherheit des Systems erhöht, da bei dem Abfall eines der Stecker immer noch die Kreise des Systems funktionstüchtig sind, deren Stecker nicht abgefallen ist.

Gemäß einer Weiterbildung der Erfindung nach Anspruch 7 erzeugen die Sensoren ein digitales pulsweitenmoduliertes oder frequenzmoduliertes Signal. Der Vorteil dieser Weiterbildung ist darin zu sehen, daß pulsweitenmodulierte bzw. frequenzmodulierte Signale eine bessere Störfestigkeit als analoge Signale aufweisen und daß darüber hinaus für eine digitale Datenübertragung weniger Übertragungsenergie benötigt wird.

Ein Ausführungsbeispiel und weitere Vorteile der Erfindung werden im Zusammenhang mit der nachstehenden Figur erläutert, die in schematischer Darstellung ein sicherheitsrelevantes System in schematischer Darstellung zeigt.

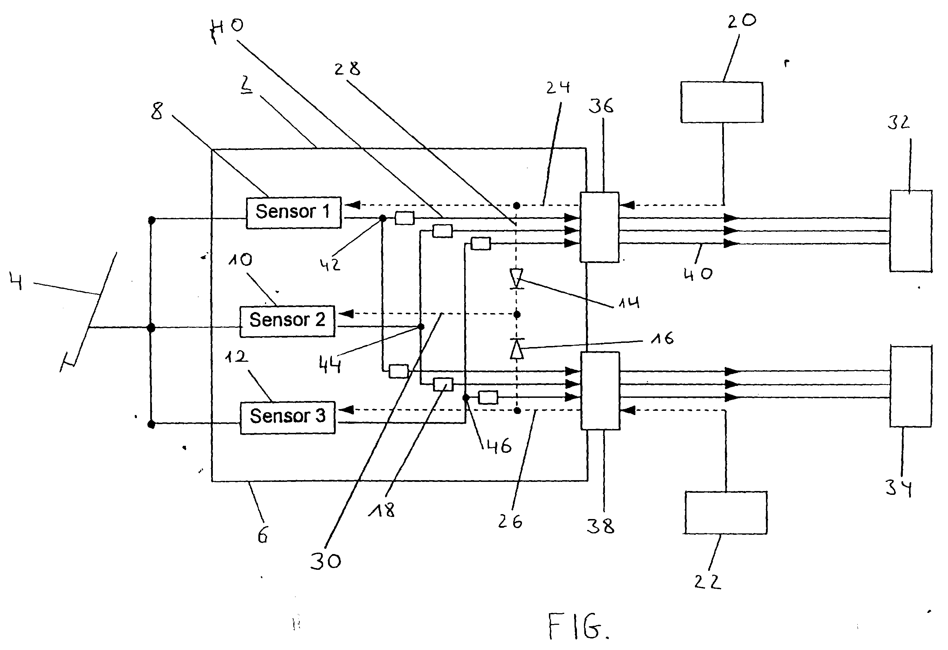

Das sicherheitsrelevante System 2, hier in Form eines elektromechanischen Bremssystems, verfügt über eine Betätigungsvorrichtung 4 in Form eines Bremspedals 4. Darüber hinaus verfügt das Bremssystem über eine Pedalsensorverteilerschaltung 6 mit den Sensoren 8, 10 und 12, die bei einer Betätigung des Bremssystems jeweils ein der Position des Bremspedals 4 entsprechendes Signal erzeugen. Die Pedalsensorverteilerschaltung 6 verfügt ferner über Dioden 14 und 16 und über Signalkreisschutzschaltungen 18. Die Sensoren 8, 10 und 12 sind über die Signalleitungen 40, die jeweils eine Signalkreisschutzschaltung 18 enthalten₁ mit den Steckern 36 bzw. 38 verbunden, über die die Signale der Sensoren 8, 10 und 12 in den ersten Bremskreis des elektromechanischen Bremssystems bzw. in den zweiten Bremskreis des elektromechanischen Bremssystems verteilt werden. In den voneinander unabhängigen Bremskreisen des Systems werden die Meßsignale der Sensoren 8, 10 und 12 auf Mikroprozessoren 32 bzw. 34 geführt (in der Figur ist lediglich für - jeden Bremskreis ein Mikroprozessor gezeigt, jeder Bremskreis kann jedoch auch über mehr Mikroprozessoren verfügen, beispielsweise kann jeder Bremsaktuator einen eigenen Mikroprozessor enthalten). Die Pedalsensorverteilerschaltung kann als ein Bauteil ausgebildet sein.

Jeder Bremskreis des Systems verfügt über eine eigene Energiequelle 20 bzw. 22, wobei die Energiequelle 20 den ersten Sensor 8 über den ersten Versorgungspfad 24 und die Energiequelle 22 den zweiten Sensor 12 über den zweiten Versorgungspfad 26 direkt mit Energie versorgt. Der erste Versorgungspfad 24 und der zweite Versorgungspfad 26 sind über eine Verbindungsleitung 28 miteinander verbunden. Die Verbindungsleitung 28 enthält zwei Dioden 14 und 16 und zwischen den beiden Dioden 14 und 16 zweigt ein dritter Versorgungspfad 30 ab, der zu dem dritten Sensor 10 führt. Die Dioden 14 und 16 sind derartig in der Verbindungleitung 28 orientiert, daß die Durchflußrichtung der ersten Diode 14 von der ersten Versorgungsleitung 24 zur dritten Versorgungsleitung 30 und die Durchflußrichtung der zweiten Diode 16 von der zweiten Versorgungsleitung 26 zur dritten Versorgungsleitung 30 weist.

Sind in dem elektromechanischen Bremssystem 2 beide Energiequellen 20 und 22 voll funktionstüchtig, so werden alle drei Sensoren 8, 10 und 12 mit Energie versorgt. Kommt es hingegen zu einem Ausfall der Energiequelle 20, so wird der erste Sensor 8 nicht mehr über den ersten Versorgungspfad 24 mit Energie versorgt. Die Sensoren 10 und 12 werden jedoch durch die Energiequelle 22 weiterhin wie folgt mit Energie versorgt. Der zweite Sensor 12 wird von der Energiequelle 22 über den zweiten Versorgungspfad 26 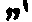 direkt" mit Energie versorgt. Der dritte Sensor 10 wird von der zweiten Energiequelle 22 über den Versorgungspfad 26, die Verbindungsleitungsleitung 28 und den dritten Versorgungspfad 30 weiterhin mit Energie versorgt, da die Durchflußrichtung der zweiten Diode 16 von der zweiten Energiequelle 22 zu dem dritten Versorgungspfad 30 bzw. zu dem dritten Sensor 10 weist. Bei einem Ausfall der ersten Energiequelle 20 kommt es also zu einem Ausfall des Meßsignals des ersten Sensors 8, wohingegen die Meßsignale der Sensoren 10 und 12 erhalten bleiben. An die Mikroprozessoren 32 bzw. 34 werden bei einer Betätigung des elektromechanischen Bremssystems also nur noch Meßsignale der Sensoren 10 und 12 weitergeleitet. In den Mikroprozessoren 32 bzw. 34 kann aufgrund der eingehenden Meßsignale eine Mehrheitsentscheidung getroffen werden, ob und in welcher Weise das elektromechanische Bremssystem betätigt wurde. Zeigen nämlich zwei von drei Sensoren ein Meßsignal an, so wird in den Mikroprozessoren 32 bzw. 34 davon ausgegangen, daß einer der Sensoren ausgefallen ist und das elektromechanische Bremssystem betätigt wird.

In den Mikroprozessoren 32 bzw. 34 kann ferner festgestellt werden, welche der Energiequellen 20 bzw. 22 ausgefallen ist. Bleibt nämlich an den Mikroprozessoren 32 bzw. 34 das Meßsignals des ersten Sensors 8 bei Vorliegen von Meßsignalen der Sensoren 10 und 12 aus, so ist dies ein Anzeichen dafür, daß die erste Energiequelle 20 ausgefallen ist, da nur diese den ersten Sensor 8 mit Energie versorgt. Dementsprechend kann durch die Mikroprozessoren 32 bzw. 34 eine entsprechende Fehlermeldung ergehen.

Die obigen Ausführungen gelten analog, wenn anstelle der Energiequelle 20 die Energiequelle 22 ausfällt. In diesem Fall wird zwar von dem zweiten Sensor 12 kein Meßsignal mehr erzeugt, jedoch von den Sensoren 8 und 10. Es sei an dieser Stelle nochmals erwähnt, daß der dritte Sensor 10, unabhängig davon, welche der Energiequellen 20 oder 22 ausfällt, immer von der jeweils anderen Energiequelle mit Energie versorgt wird.

Jede Signalleitung 40, die einen der Sensoren 8, 10 bzw. 12 mit einem der Bremskreise des elektromechanischen Systems verbindet, weist eine Signalkreisschutzschaltung 18 auf, über die eine elektrische Entkopplung zwischen den Sensoren und den Kreisen des elektromechanischen Bremssystems vorgenommen wird. Tritt also beispielsweise in dem Bremskreis, der von der Energiequelle 20 mit Energie versorgt wird, ein elektrischer Fehler auf, so wirkt sich dieser Fehler aufgrund der Signalkreisschutzschaltungen 18 nicht auf die Sensoren 8, 10 und 12 aus, so daß die Meßsignale der Sensoren weiterhin für den zweiten Bremskreis zur Verfügung stehen. Vorzugsweise sind die Signalkreisschutzschaltungen 18 unmittelbar hinter den Verzweigungspunkten 42, 44 und 46 (von den Sensoren aus gesehen), in denen sich die Signalleitung eines Sensors in zwei Zweige aufteilt, von denen jeweils einer auf einen der Stecker 36 bzw. 38 geführt wird, angeordnet, so daß sich zwischen den Sensoren und den Signalkreisschutzschaltungen keine weiteren elektrischen Bauteile befinden.

### Bezugszeichenliste

- 2: sicherheitsrelevantes System
- 4: Betätigungsvorrichtung
- 6: Pedalsensorverteilerschaltung
- 8, 10, 12: Sensoren
- 14, 16: Dioden
- 18: Signalkreisschutzschaltungen
- 20, 22: Energiequellen
- 24: erster Versorgungspfad
- 26: zweiter Versorgungspfad
- 28: Verbindungsleitung
- 30: dritter Versorgungspfad
- 32, 34: Mikroprozessoren
- 36, 38: Stecker
- 40: Signalleitungen
- 42,44,46: Verzweigungspunkte

## Patentansprüche

1. Sicherheitsrelevantes System (2), insbesondere elektromechanisches Bremssystem (2), das folgende Bestandteile enthält:
- eine Betätigungsvorrichtung (4), die von einer Ausgangsposition in unterschiedliche Positionen überführbar ist
- drei Sensoren (8, 10, 12), von denen unabhängig voneinander ein der Position der Betätigungsvorrichtung (4) entsprechendes Meßsignal erzeugbar ist, wobei der erste (8) der drei Sensoren (8, 10, 12) über einen ersten Versorgungspfad (24) von einer ersten unabhängigen Energiequelle (20) und der zweite (12) der drei Sensoren (8, 10, 12) über einen zweiten Versorgungspfad (26) von einer zweiten unabhängigen Energiequelle (22) mit Energie versorgt wird,
**dadurch gekennzeichnet, daß**
- der erste (24) und der zweite Versorgungspfad (26) über eine Verbindungsleitung (28) miteinander verbunden sind, die zwei Dioden (14, 16) bzw. zwei Elemente, die die Funktion einer Diode haben, enthält und
- daß zwischen der ersten (14) und der zweiten Diode (16) ein dritter Versorgungspfad (30) von der Verbindungsleitung (28) abzweigt, der zu dem dritten Sensor (10) führt und daß die Dioden (14, 16) derartig in der Verbindungsleitung (28) orientiert sind, daß die Durchflußrichtung der ersten Diode (14) von dem ersten Versorgungspfad (24) zum dritten Versorgungspfad (30) und die Durchflußrichtung der zweiten Diode (16) von dem zweiten Versorgungspfad (26) zum dritten Versorgungspfad (30) weist.

2. Sicherheitsrelevantes System (2) nach Anspruch 1, dadurch gekennzeichnet daß das System (2) über mindestens zwei funktional voneinander unabhängige Kreise verfügt, wobei der erste Kreis von der ersten Energiequelle (20) und der zweite Kreis von der zweiten Energiequelle (22) versorgt wird und jedem Kreis die Meßsignale aller drei Sensoren (8, 10, 12) zugeführt werden.

3. Sicherheitsrelevantes System (2) nach Anspruch 2, dadurch gekennzeichnet, daß die Meßsignale aller drei Sensoren (8, 10, 12) in jedem Kreis einer intelligenten Einheit (32, 34) zugeführt werden und in der intelligenten Einheit (32, 34) eine Mehrheitsentscheidung und ggf. eine Plausibilitätsbetrachtung durchgeführt wird.

4. Sicherheitsrelevantes System (2) nach einem der Ansprüche 2 bis 3, dadurch gekennzeichnet, daß jede Signalleitung (40), die von einem der Sensoren (8, 10, 12) zu einem der Kreise des Systems (2) führt, eine Signalkreisschutzschaltung (18) enthält, über die eine elektrische Entkopplung zwischen dem Sensor (8, 10, 12) und dem jeweiligen Kreis des Systems vorgenommen wird, wenn in dem jeweiligen Kreis ein elektrischer Fehler auftritt.

5. Sicherheitsrelevantes System (2) nach Anspruch 4, dadurch gekennzeichnet, daß sich zwischen dem Sensor (8, 10, 12) und der Signalkreisschutzschaltung keine elektrischen Bestandteile des jeweiligen Kreises befinden.

6. Sicherheitsrelevantes System (2) nach einem der Ansprüche 2 bis 5, dadurch gekennzeichnet, daß für jeden Kreis des Systems ein separater Stecker (36, 38) vorhanden ist, über den die Signale aller drei Sensoren (8, 10, 12) dem jeweiligen Kreis zugeführt werden.

7. Sicherheitsrelevantes System (2) nach einem der Ansprüche 1 bis 3, dadurch gekennzeichnet, daß die Sensoren (8, 10, 12) ein digitales pulaweitenmoduliertes oder frequenzmoduliertes Signal erzeugen.
